# EUROPEAN PATENT APPLICATION

(11) **EP 4 366 169 A1**
(43) Date of publication of application: **08.05.2024**
(21) Application number: 23207200.9
(22) Date of filing: 31.10.2023
(51) Int. Cl.: H03K 17/96

(54) **A CONTROL PANEL AND CONTROL METHOD THEREOF**

(30) Priority: 07.11.2022 TR 202216773
(71) Applicant: Arçelik Anonim Sirketi, 34445 Istanbul (TR)
(72) Inventor: YUCE, HAMIT TAYLAN, 34445 ISTANBUL (TR); YALCIN, SERKAN, 34445 ISTANBUL (TR); DIK, ENGIN, 34445 ISTANBUL (TR); INCI, BILAL, 34445 ISTANBUL (TR); GUVEN, RESUL, 34445 ISTANBUL (TR)

(57) **Abstract**

The present invention relates to a control panel (1) having at least one touch surface (4), and comprising, on the touch surface (4), at least one first sensor (2) which is positioned so as to be visible to the user and which is assigned at least one function related to the operation of the household appliance and at least two second sensors (3) which are positioned so as to be hidden from the user and adjacent to the first sensor (1) and which are not assigned any function related to the operation of the household appliance.

## Description

The present invention relates to a control panel which has a touch surface and wherein erroneous detections caused by unintentional contact with the touch surface are prevented, and relates to the control method thereof.

Control panels having touch surfaces are used in household appliances, especially dishwashers. On touch surfaces, detection is carried out with capacitive sensitivity, and when a sufficient capacitive field is created as a result of the user pressing the designated areas on the touch surface, the desired function assigned to the area is performed.

Especially, control panels of dishwashers which are installed in frequently used places such as kitchens, are vulnerable to erroneous detections due to unintentional contact with the touch surface. In this case, as a result of unintentional contact with the touch surface, problems such as unintentional turning-on of a turned-off household appliance, turning-off of a working household appliance, or stopping the program which lead to user complaints arise.

In the state of the art European Patent Applications No. EP2379789 and EP0859296, household appliances are disclosed, comprising control panels which have touch surfaces.

The aim of the present invention is the realization of a household appliance control panel having a touch surface wherein erroneous detections caused by unintentional contact with the touch surface are prevented, and the realization of the control method thereof.

The household appliance control panel realized in order to attain the aim of the present invention, explicated in the first claim and the respective claims thereof, has at least one touch surface, and comprises, on the touch surface, at least one first sensor which is positioned so as to be visible to the user and which is assigned at least one function related to the operation of the household appliance and at least two second sensors which are positioned so as to be hidden from the user and adjacent to the first sensor and which are not assigned any function related to the operation of the household appliance.

In the embodiment of the present invention, even if the first sensor is touched, the first sensor performs its assigned function as long as both of the second sensors adjacent to the first sensor are not touched at the same time. When the second sensors and the first sensor are touched at the same time, the function assigned to the first sensor is not performed. When the two second sensors and the first sensor are touched at the same time, this contact is perceived as unintentional contact with the touch surface and therefore the function assigned to the first sensor is not performed. Thus, it is ensured that the household appliance operates within the program set by the user, even as a result of unintentional contact with the touch surface.

In the preferred embodiment of the present invention, the touch surface comprises a front surface which forms the visual outer surface of the control panel, which is visible to and touched by the user, and a rear surface which is provided just behind the front surface, where the first and second sensors are positioned and where the contact with the front surface is detected. The first and second sensors are disposed on the rear surface in the positions determined by the manufacturer. The parts on the front surface corresponding to the part where the first sensors on the rear surface are located are marked so as to be viewed from the outside. In this embodiment, the parts on the front surface corresponding to the part where the second sectors on the rear surface are located are not marked on the front surface. Therefore, an observer looking at the control panel from outside perceives the parts where the first sensors are located, but cannot perceive the parts where the second sensors are located.

In an embodiment of the present invention, the control panel comprises at least one first sensor which performs the turn on/turn off function.

In another embodiment of the present invention, the control panel comprises at least one first sensor which performs the start/pause function.

In an embodiment of the present invention, the second sensors are positioned around the first sensors so as to be opposite to each other for example at the bottom / top, on the right / left.

By means of the present invention, it is ensured that the household appliance operates within the program set by the user, even as a result of unintentional contact with the touch surface. Moreover, the problems which may arise as a result of erroneous detections due to unintentional contact especially with the touch surfaces of the control panels of the dishwashers, located in frequently used places such as kitchens, and which lead to user complaints are eliminated.

A control panel and the control method thereof realized in order to attain the aim of the present invention are illustrated in the attached figure, where:
Figure 1 - is the view of a control panel having a touch surface.
Figure 2 - is the view of the rear surface.

The elements illustrated in the figures are numbered as follows:
1. Control panel
2. First sensor
3. Second sensor
4. Touch surface
5. Front surface
6. Rear surface

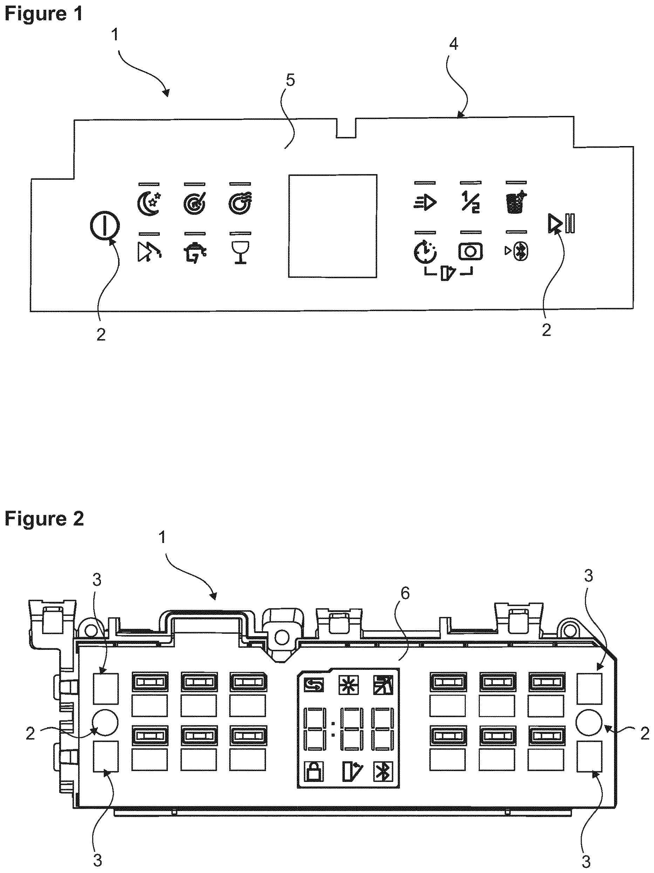

The control panel (1) has at least one touch surface (4), and comprises, on the touch surface (4), at least one first sensor (2) which is positioned so as to be visible to the user and which is assigned at least one function related to the operation of the household appliance and at least two second sensors (3) which are positioned so as to be hidden from the user and adjacent to the first sensor (1) and which are not assigned any function related to the operation of the household appliance (Figure 1).

In the embodiment of the present invention, even if the first sensor (2) is touched, the first sensor (2) performs its assigned function as long as both of the second sensors (3) adjacent to the first sensor (2) are not touched at the same time. When all the second sensors (3) and the first sensor (2) are touched at the same time, the function assigned to the first sensor (2) is not performed. When the two second sensors (3) and the first sensor (2) are touched at the same time, this contact is perceived as unintentional contact with the touch surface (4) and therefore the function assigned to the first sensor (2) is not performed. Thus, it is ensured that the household appliance operates within the program set by the user, even as a result of unintentional contact with the touch surface (4).

In the preferred embodiment of the present invention, the touch surface (4) comprises a front surface (5) which forms the visual outer surface of the control panel (1), which is visible to and touched by the user, and a rear surface (6) which is provided just behind the front surface (5), where the first and second sensors (2 and 3) are positioned and where the contact with the front surface (5) is detected. The first and second sensors (2 and 3) are disposed on the rear surface (6) in the positions determined by the manufacturer. The parts on the front surface (5) corresponding to the part where the first sensors (2) on the rear surface (6) are located are marked so as to be viewed from the outside. In this embodiment, the parts on the front surface (5) corresponding to the part where the second sectors (3) on the rear surface (6) are located are not marked on the front surface. Therefore, an observer looking at the control panel (1) from outside perceives the parts where the first sensors (2) are located, but cannot perceive the parts where the second sensors (3) are located (Figure 2).

In an embodiment of the present invention, the control panel (1) comprises at least one first sensor (2) which performs the turn on/turn off function.

In another embodiment of the present invention, the control panel (1) comprises at least one first sensor (29 which performs the start/pause function.

In an embodiment of the present invention, the second sensors (3) are positioned around the first sensors (2) so as to be opposite to each other for example at the bottom / top, on the right / left. In this embodiment of the present invention, the first sensor (2) is positioned between the two second sensors (3).

In the embodiment of the present invention, the control panel (1) is used in household appliances, preferably in dishwashers.

The control method of the control panel of the present invention comprises the step of the first sensor (2) performing its assigned function as long as both of the second sensors (3) adjacent to the first sensor (2) are not touched at the same time even if the first sensor (2) is touched. The control method comprises the step of preventing the first sensor (2) from performing its assigned function when all the second sensors (3) and the first sensor (2) are touched at the same time. Thus, it is ensured that the function assigned to the first sensor (2) is not performed only when the two second sensors (3) and the first sensor (2) are touched at the same time. Consequently, said contact is enabled to be detected as unintentional contact with the touch surface (4). Moreover, it is ensured that the household appliance operates within the program set by the user, even as a result of unintentional contact with the touch surface (4).

By means of the present invention, it is ensured that the household appliance operates within the program set by the user, even as a result of unintentional contact with the touch surface (4). Moreover, the problems which may arise as a result of erroneous detections due to unintentional contact especially with the touch surfaces (4) of the control panels (1) of the dishwashers, located in frequently used places such as kitchens, and which lead to user complaints are eliminated.

## Claims

1. A control panel (1) having at least one touch surface (4), and **comprising,** on the touch surface (4), at least one first sensor (2) which is positioned so as to be visible to the user and which is assigned at least one function related to the operation of the household appliance, **characterized by** at least two second sensors (3) which are positioned so as to be hidden from the user and adjacent to the first sensor (1) and which are not assigned any function related to the operation of the household appliance.

2. A control panel (1) as in Claim 1, **characterized by** the touch surface (4) comprising a front surface (5) which forms the visual outer surface of the control panel (1), which is visible to and touched by the user, and a rear surface (6) which is provided just behind the front surface (5), where the first and second sensors (2 and 3) are positioned and where the contact with the front surface (5) is detected.

3. A control panel (1) as in Claim 2, **characterized by** the first and second sensors (2 and 3) which are disposed on the rear surface (6) in the positions determined by the manufacturer.

4. A control panel (1) as in Claim 2 or 3, **characterized by** the front surface (5) of which the parts corresponding to the part where the first sensors (2) on the rear surface (6) are located are marked so as to be viewed from the outside.

5. A control panel (1) as in any one of Claims 2 to 4, **characterized by** the front surface (5) of which the parts corresponding to the part where the second sensors (3) on the rear surface (6) are located are not marked.

6. A control panel (1) as in any one of the above claims, **characterized by** at least one first sensor (2) which performs the turn on/turn off function.

7. A control panel (1) as in any one of the above claims, **characterized by** at least one first sensor (2) which performs the start/pause function.

8. A control panel (1) as in any one of the above claims, **characterized by** the second sensors (3) which are positioned around the first sensors (2) so as to be opposite to each other.

9. A control panel (1) as in any one of the above claims, **characterized by** the first sensor (2) which is positioned between the two second sensors (3).

10. A control method which is suitable for the control panel (1) as in any one of the above claims, comprising the step of the first sensor (2) performing its assigned function as long as both of the second sensors (3) adjacent to the first sensor (2) are not touched at the same time even if the first sensor (2) is touched.

11. A control method which is suitable for the control panel (1) as in any one of the above claims, comprising the step of preventing the first sensor (2) from performing its assigned function when all the second sensors (3) and the first sensor (2) are touched at the same time.

12. A control panel (1) as in any one of the above claims, **characterized by** being used in a household appliance.

13. A control panel (1) as in Claim 12, **characterized by** the household appliance which is a dishwasher.
